# EUROPEAN PATENT SPECIFICATION

(11) **EP 4 156 153 B1**
(45) Date of publication and mention of the grant of the patent: **28.01.2026**
(21) Application number: 21943317.4
(22) Date of filing: 26.09.2021
(51) Int. Cl.: G09F 9/30, H05K 5/02, H04M 1/02, G06F 1/16

(54) **FLEXIBLE SCREEN EXTENSION/RETRACTION STRUCTURE AND ELECTRONIC DEVICE**
VERLÄNGERUNGS-/EINZUGSSTRUKTUR FÜR FLEXIBLEN BILDSCHIRM UND ELEKTRONISCHE VORRICHTUNG
STRUCTURE D'EXTENSION/DE RÉTRACTION D'ÉCRAN SOUPLE ET DISPOSITIF ÉLECTRONIQUE

(30) Priority: 11.08.2021 CN 202110918370
(43) Date of publication of application: 29.03.2023
(73) Proprietor: Wingtech Technology (Shenzhen) Co., Ltd., Shenzhen City, Guangdong 518003 (CN)
(72) Inventor: ZHANG, Jiatao, Shenzhen, Guangdong 518003 (CN)
(74) Representative: Grünecker Patent- und Rechtsanwälte PartG mbB
(86) International application number: PCT/CN2021/120730
(87) International publication number: WO 2023/015688

(56) References cited:
- CN-A- 111 833 748
- CN-A- 111 901 457
- CN-A- 112 189 179
- CN-A- 112 799 470
- CN-A- 113 099 007
- CN-A- 113 570 974
- US-A1- 2020 363 841
- US-A1- 2021 218 835

## Description

### TECHNICAL FIELD

The present disclosure relates to a flexible screen telescopic structure and an electronic device.

### BACKGROUND

The existing structure and size of mobile terminal products cannot be curled and stretched, and extended and retracted due to the hard screen, which causes the limitations of the screen in the use process of users, thus greatly reducing the performance of office and entertainment. The large-screen terminal products are inconvenient to carry and the small-screen terminal products have poor experience, so that the traditional mobile terminal products have gradually failed to meet the needs of people's lives.

Compared with traditional screens, flexible screens have the characteristics of strong flexibility and bendability, which can reduce the degree of accidental damage of equipment, and have a higher degree of durability than that of other screens. Because of their low-power consumption and bendable characteristics, the flexible screens have a profound impact on the application of wearable devices. With the progress of science and technology, the application of flexible screens in electronic products in life has been increasing.

CN111901457A discloses an electronic equipment, comprising a flexible screen that can be switched to a contraction state from an extension state, and a driving assembly that can move along the moving part in the direction close to the fixed part, and a return elastic piece can dirve a rotating shaft to rotate, so that the flexible screen is driven to contract.

However, the existing flexible electronic devices, with a large-sized screen achieved, have a large overall volume due to the folded structure.

In view of this, it is particularly important to develop a flexible screen telescopic structure and an electronic device that can solve the above technical problems.

### SUMMARY

### (I) The technical problem to be solved

The technical problem to be solved by the present disclosure is to solve the problem that the existing flexible electronic device, with a large-sized screen achieved, has a large overall volume due to a folded structure.

### (II) Technical solutions

It is an object of the present disclosure to provide a flexible screen telescopic structure and an electronic device that are compact and small in volume.

A flexible screen telescopic structure includes a middle frame support, a sliding support, a driving mechanism and a flexible screen;
the sliding support is slidably connected to the middle frame support, and the flexible screen is connected to a first side surface of the middle frame support and bypasses an abutting edge of the sliding support;
the driving mechanism comprises a driving member, a guide member and a transmission rope, wherein the guide member is rotatably connected to the middle frame support; the transmission rope is wound around the guide member and is connected to the driving member, and the transmission rope is connected to the sliding support, with the connected part being a connecting portion; the driving member is used for driving the transmission rope to move around the guide member, and enables the connecting portion to drive the sliding support to move in a first direction, thereby pushing the flexible screen through the abutting edge, so that the flexible screen moves around the abutting edge and is gradually stretched on the first side surface, the first direction being parallel to the first side surface;
the driving mechanism includes two groups of the guide members, each group of the guide members comprising at least one guide wheel, the two groups of the guide members being respectively arranged close to both ends of the middle frame support in a second direction; the second direction is perpendicular to the first direction and parallel to the first side surface;
the transmission rope is wound around the guide wheels of the two groups of the guide members; the transmission rope has two connecting portions which are respectively arranged close to the both ends of the middle frame support in the second direction for jointly driving the sliding support to slide relative to the middle frame support;
each group of the guide members includes two of the guide wheels; the transmission rope is wound around four of the guide wheels in an 8-shaped manner in sequence; and two of the connecting portions are respectively located between two of the guide wheels of each of the two groups of the guide members.

As an alternative to the embodiment of the present disclosure, the driving member includes a driving portion and a driving wheel connected to each other; the transmission rope being is arranged at least one turn around the driving wheel; and the driving portion is capable of rotating the driving wheel so as to move the transmission rope via the driving wheel.

As an alternative to the embodiments of the present disclosure, the transmission rope is endless and wound around the driving wheel and the guide wheel successively.

As an alternative to the embodiments of the present disclosure, the driving member further comprises a worm wheel and a worm cooperating with each other; the worm wheel is connected to the driving wheel; and the driving portion is connected to the worm and can rotate the worm wheel via the worm, thereby rotating the driving wheel via the worm wheel.

As an alternative embodiment of the embodiment of the present disclosure, the flexible screen is wound via the abutting edge to a second side surface of the middle frame support opposite to the first side surface;
the driving mechanism further includes a reset elastic member, one end of the reset elastic member is connected to a portion of the flexible screen located on the second side surface, and the other end is connected to the middle frame support or the sliding support; the driving member can also move the transmission rope so that the connecting portion moves the sliding support in a third direction opposite to the first direction; and meanwhile, the reset elastic member can move the flexible screen in the third direction so as to retract the flexible screen to the second side surface.

As an alternative to the embodiments of the present disclosure, the flexible screen telescopic structure further includes a sliding connecting block, and a first sliding rail is provided on the middle frame support;
the first sliding rail extends in the first direction, and the sliding connecting block is slidably connected to the first sliding rail and is connected to the sliding support and the connecting portion so as to connect the sliding support and the connecting portion.

As an alternative to the embodiments of the present disclosure, a plurality of sliding connecting strips are provided on the middle frame support; and a plurality of sliding connecting grooves are provided on the sliding support, and the plurality of sliding connecting grooves are arranged at intervals and cooperate with the plurality of sliding connecting strips to slidably connect the sliding support and the middle frame support.

As an alternative to the embodiments of the present disclosure, the flexible screen bypasses and moves around the abutting edge and is rolled up at the abutting edge.

As an alternative to the embodiments of the present disclosure, the abutting edge is provided with a rotatable abutting roller; the back of the flexible screen is provided with a supporting track; and the abutting edge abuts against the supporting track via the abutting roller.

As an alternative to the embodiments of the present disclosure, the flexible screen telescopic structure further includes a housing; the housing is covered on the second side surface, slidably coupled to the middle frame support, and connected to the sliding support, so that the housing slides along the first direction with the sliding support.

As an alternative to the embodiments of the present disclosure, the flexible screen telescopic structure further includes a back shell; the back shell is covered on the second side surface and connected to the middle frame support, and the housing is sleeved outside the back shell.

An electronic device includes the flexible screen telescopic structure. The flexible screen telescopic structure includes a middle frame support, a sliding support, a driving mechanism and a flexible screen; the sliding support is slidably connected to the middle frame support, and the flexible screen is connected to a first side surface on the middle frame support and bypasses an abutting edge of the sliding support; the driving mechanism comprises a driving member, a guide member and a transmission rope, wherein the guide member is rotatably connected to the middle frame support; the transmission rope is wound around the guide member and is connected to the driving member, and the transmission rope is connected to the sliding support, with the connected part being a connecting portion; the driving member is used for driving the transmission rope to move around the guide member, and enables the connecting portion to drive the sliding support to move in a first direction, thereby pushing the flexible screen through the abutting edge, so that the flexible screen moves around the abutting edge and is gradually stretched on the first side surface, the first direction being parallel to the first side surface.

In order that the above-mentioned objects, features and advantages of the present disclosure may be more readily appreciated, a more particular description of preferred embodiments of the invention will be given below when taken in conjunction with the accompanying drawings.

### BRIEF DESCRIPTION OF THE DRAWINGS

In order to clarify more clearly the technical solution of the embodiments of the present disclosure, the accompanying drawings required to be used in the embodiment are briefly described below. It should be understood that the following drawings depict only certain embodiments of the disclosure and are therefore not to be considered limiting of the scope. For a person of ordinary skill in the art, other relevant figures can also be obtained according to these drawings without involving any inventive effort.
Fig. 1 is a structure diagram of a flexible screen telescopic structure applied to an electronic device and stretched according to one or more embodiments of the present disclosure.
Fig. 2 is a structure diagram of a flexible screen telescopic structure applied to an electronic device and retracted according to one or more embodiments of the present disclosure.
Fig. 3 is an exploded diagram of a flexible screen telescopic structure applied to an electronic device according to one or more embodiments of the present disclosure.
Fig. 4 is a structure diagram of a part of a flexible screen telescopic structure when retracted according to one or more embodiments of the present disclosure.
Fig. 5 is a structure diagram of a part of a flexible screen telescopic structure when stretched according to one or more embodiments of the present disclosure.
Fig. 6 is a sectional structure diagram at F-F in Fig. 2.

Reference numerals: 100-electronic device; 20-battery; 10-flexible screen telescopic structure; 11-middle frame support; 112-second side surface; 1121-first sliding rail; 113-sliding connecting strip; 12-sliding support; 121-abutting edge; 122-abutting roller; 13-driving mechanism; 131-driving member; 1311-driving portion; 1312-worm; 1313-worm wheel; 1314-driving wheel; 132-guide member; 133-guide wheel; 134-transmission rope; 1341-connecting portion; 14-flexible screen; 141-supporting track; 15-sliding connecting block; 16-housing; 17-back shell; A-first direction; C-third direction; B-second direction.

### DETAILED DESCRIPTION OF THE INVENTION

In order to make the objects, aspects and advantages of the embodiments of the present disclosure more apparent, the technical solutions in the embodiments of the present disclosure will be described in detail and completely in conjunction with the accompanying drawings in the embodiments of the present application. It is obvious that the described embodiments are part of, but not all of, the disclosure. The components of the embodiments of the disclosure generally described and illustrated in the drawings herein may be arranged and designed in a variety of different configurations.

It should be noted that same numbers and letters refer to same items in the following drawings. Thus, once an item is defined in one figure, it need not be further defined and explained in the following figures. The terms "upper", "lower", "inner", "outer", "left", "right", and the like indicate orientations or positional relationships based on those shown in the drawings, or orientations or positional relationships that are customarily present in the use of the inventive products, or orientations or positional relationships that are customarily understood by those skilled in the art, merely to facilitate the description of the present disclosure and simplify the description, which do not indicate or imply that the referenced devices or elements must have a particular orientation, be constructed and operated in a particular orientation, and thus should not be construed to limit the present disclosure. The terms "first", "second", and the like are used solely for descriptive purposes and are not to be construed as indicating or implying relative importance. The terms "including", "comprising", or any other variation thereof, are intended to cover a non-exclusive inclusion, such that a process, a method, an article, or a device that includes a list of elements does not include only those elements but may include other elements not expressly listed or inherent to such process, method, article, or device. An element defined by the language "including a" does the without more constraints, preclude the existence of additional identical elements in the process, method, article, or device that includes the element.

It should also be noted that, unless expressly stated or limited otherwise, the terms "provided", "connected", and the like should be construed broadly. For example, "connected" may be fixed, detachable, or integrally connected; and may be a mechanical connection or an electrical connection. It may be directly connected or indirectly connected by an intermediate medium, and may be the communication between two elements. The specific meaning of the above terms in this disclosure can be understood by one of ordinary skill in the art depending on the particular circumstances.

The implementation of this disclosure is described in detail in combination with the accompanying drawings below.

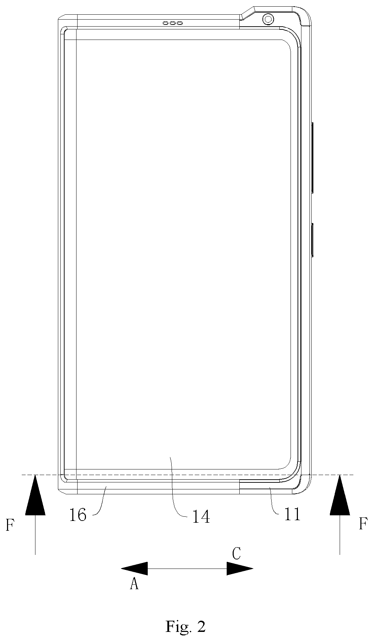

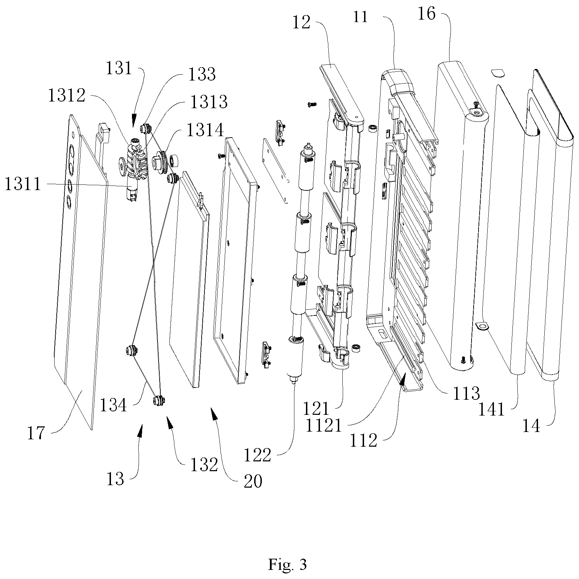

Referring to Figs. 1, 2 and 3, Fig. 1 is a structure diagram of a flexible screen telescopic structure 10 applied to an electronic device 100 and stretched according to an embodiment of the present disclosure. Fig. 2 is a structure diagram of a flexible screen telescopic structure 10 applied to an electronic device 100 and retracted according to an embodiment of the present disclosure. Fig. 3 is an exploded diagram of a flexible screen telescopic structure 10 applied to an electronic device 100 according to an embodiment of the present disclosure.

Embodiments of the present disclosure provide a flexible screen telescopic structure 10 that is compact and small in volume. The flexible screen telescopic structure 10 can be applied to electronic devices 100, wearable devices, and the like that require a flexible display panel.

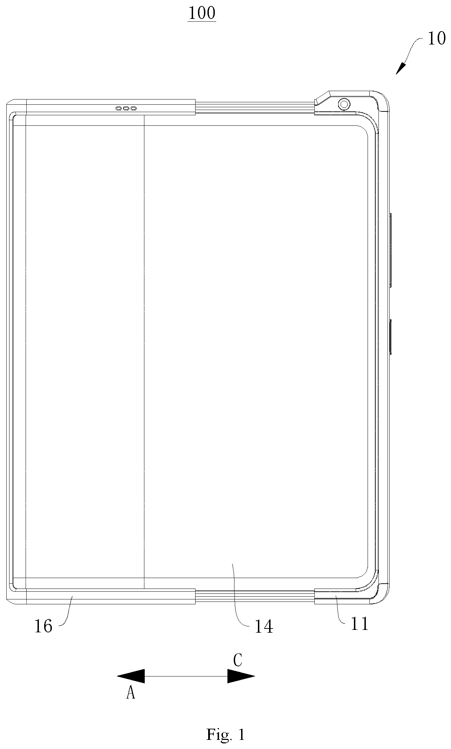

When the flexible screen telescopic structure 10 is applied to the electronic device 100, the electronic device 100 is stretched or contracted by the flexible screen telescopic structure 10 to increase or decrease the display area. It should be noted that the electronic device 100 may be a computing device such as a laptop computer, a computer monitor including an embedded computer, a tablet computer, a cellular phone, a media player, or other hand-held or portable electronic device 100, a television, a computer display not including an embedded computer, a gaming device, a navigation device, an embedded system (such as a system in which an electronic device 100 with a display is installed in a kiosk or automobile), a device that implements the functionality of two or more of these devices, or other electronic devices 100. In the exemplary configurations of Figs. 1 and 2, the electronic device 100 is a portable device, such as a cellular telephone, a media player, a tablet computer, or other portable computing devices. Other configurations may be used for the electronic device 100, if desired. The examples of Figs. 1 and 2 are merely exemplary. Since the electronic device 100 employs the flexible screen telescopic structure 10 provided by embodiments of the present disclosure, the electronic device 100 is also compact and small in volume.

The structural composition, principles of operation, and advantages of the flexible screen telescopic structure 10 provided by embodiments of the present disclosure are described in detail below.

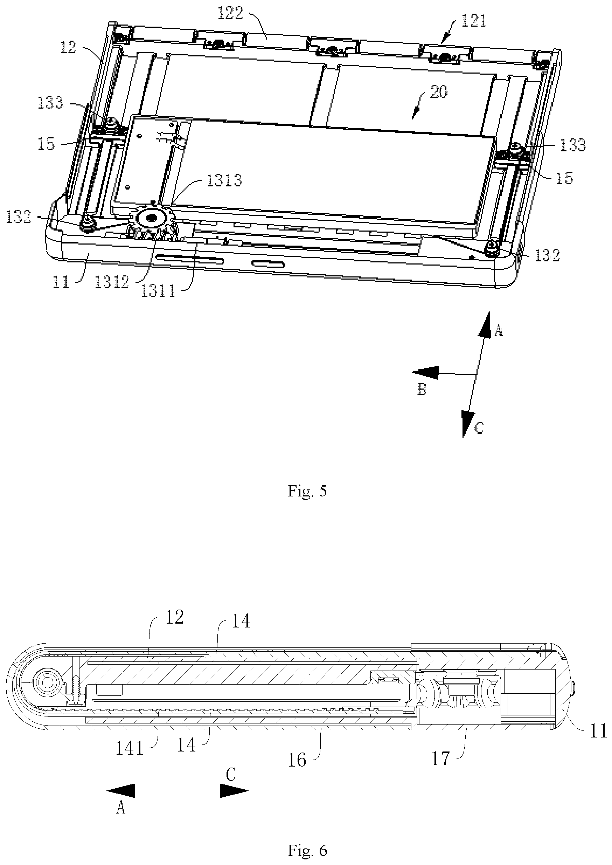

With continued reference to Fig. 3, and with reference to Figs. 4, 5, and 6, Fig. 4 is a structure diagram of a part of the flexible screen telescopic structure 10 when retracted according to an embodiment of the present disclosure. Fig. 5 is a structure diagram of a part of a flexible screen telescopic structure stretched according to an embodiment of the present disclosure. Fig. 6 is a sectional structure diagram at F-F in Fig. 2. In Figs. 1, 2, 4, 5, and 6, the direction indicated by the arrow A is a first direction A, the direction indicated by the arrow B is a second direction B, and the direction indicated by the arrow C is a third direction C.

The flexible screen telescopic structure 10 includes a middle frame support 11, a sliding support 12, a driving mechanism 13 and a flexible screen 14. Herein, the sliding support 12 is slidably connected to the middle frame support 11. The flexible screen 14 is connected to a first side surface (not shown) on the middle frame support 11, and bypasses around an abutting edge 121 on the sliding support 1. In other words, one part of the flexible screen 14 extends along the first side surface, and the other part bypasses around the abutting edge 121. The driving mechanism 13 includes a driving member 131, a guide member 132 and a transmission rope 134. The guide member 132 is rotatably connected to the middle frame support 11. The transmission rope 134 is wound around the guide member 132 and is connected to the driving member 131. The transmission rope 134 is connected to the sliding support 12, with the connected part being a connecting portion 1341 (not shown). The driving member 131 can drive the transmission rope 134 to move around the guide member 132, and also enables the connecting portion 1341 to drive the sliding support 12 to move in the first direction A parallel to the first side surface, so that the abutting edge 121 moving in the first direction A abuts against and pushes the flexible screen 14, and a part of the flexible screen 14 which bypasses the abutting edge 121 is gradually stretched on the first side surface. In other words, as the driving member 131 moves the transmission rope 134, the connecting portion 1341 moves the sliding support 12 relative to the middle frame support 11 in the first direction A, and the abutting edge 121 moving in the first direction A pushes the flexible screen 14 which is wound on the abutting edge 121, so that the above-mentioned part of the flexible screen 14 moves in the circumferential direction of the abutting edge 121 and is gradually stretched on the first side surface. The object of stretching the flexible screen 14 is thus achieved by using the sliding support 12 slidably connected to the middle frame support 11. It is simple and compact in structure and makes the overall volume small.

However, the existing foldable flexible display device has a relatively complicated and large rotational connection structure due to its rotational connection mode, which also makes the overall volume of the electronic device 100 relatively large and less convenient to use.

Further, the driving mechanism 13 may include two groups of guide members 132 each including at least one guide wheel 133, and the two groups of guide members 132 are respectively provided close to both ends of the middle frame support 11 in the second direction B, wherein the second direction B is perpendicular to the first direction A and parallel to the first side surface. In addition, the transmission rope 134 is wound around the guide wheels 133 of the two groups of guide members 132, and the transmission rope 134 has two connecting portions 1341 which are respectively arranged close to the both ends of the middle frame support 11 in the second direction B for jointly driving the sliding support 12 to slide relative to the middle frame support 11. In other words, the two connecting portions 1341 of the transmission rope 134 are respectively approximately located at the both ends of the middle frame support 11 in the second direction B by means of being wound around the two groups of guide members 132, so that the sliding support 12 is driven to slide relative to the middle frame support 11 from the both ends of the middle frame support 11 in the second direction B by the two connecting portions 1341, so as to improve the smoothness of the movement of the sliding support 12.

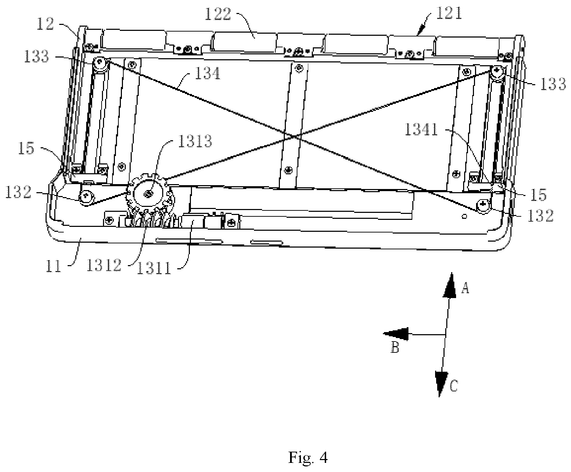

Note that, in the present embodiment, each group of the guide members 132 includes two guide wheels 133. The transmission rope 134 is wound around the four guide wheels 133 in an 8-shaped manner, and two connecting portions 1341 are respectively located between the two guide wheels 133 of each of the two groups of the guide members 132, as shown in Figs. 3, 4 and 5. Taking Fig. 4 as an example, the transmission rope 134 is wound back to the driving member 131 from a driving member 131, a lower left guide wheel 133, an upper left guide wheel 133, a lower right guide wheel 133 and an upper right guide wheel 133 in sequence, and forms an 8-shaped shape, such that when the driving member 131 drives the transmission rope 134 to move, a connecting portion 1341 between the lower left guide wheel 133 and the upper left guide wheel 133 and a connecting portion 1341 between the lower right guide wheel 133 and the upper right guide wheel 133 move in the first direction A so as to achieve the purpose that the two connecting portions 1341 move the sliding member together. The winding method described above can compress the transmission rope 134 against the guide wheel 133, and the length of the transmission rope 134 is short and the transmission accuracy is high,

In addition, in other embodiments, the number of guide wheels 133 may be other numbers, and the manner in which the transmission rope 134 is wound may be other way. In addition, the part of the flexible screen 14 that bypasses around the abutting edge 121 may also be rolled up nearby the abutting edge 121.

Further, the driving member 131 may include a driving portion 1311 and a driving wheel 1314 connected to each other. The transmission rope 134 is arranged at least one turn around the driving wheel 1314. The driving portion 1311 can rotate the driving wheel 1314 to move the transmission rope 134 via the driving wheel 1314. In other words, the transmission rope 134 is wound around the driving wheel 1314, so that the connection between the transmission rope 134 and the driving wheel 1314 is achieved in a simple manner, facilitating assembly and adjustment.

Furthermore, in the present embodiment, the transmission rope 134 is endless, or the transmission rope 134 has a ring shape. The transmission rope 134 is successively wound around the driving wheel 1314 and the guide wheel 133 so as to realize transmission by a ring of the transmission rope 134, and it has a simple structure and is easy for assembly and adjustment. It should be noted that the transmission rope 134 may also be a flexible drive such as a drive belt, a timing belt, a chain, etc.

Furthermore, the driving member 131 further includes a worm wheel 1313 and a worm 1312 cooperating with each other. The worm wheel 1313 is connected to the driving wheel 1314. The driving portion 1311 is connected to the worm 1312 and can rotate the worm 1312 to rotate the worm wheel 1313 via the worm 1312, so as to further rotate the driving wheel 1314 via the worm 1313. By providing the structure of the worm wheel 1313 and the worm 1312, the driving wheel 1314 can be locked when the driving portion 1311 stops rotating, so that it can reduce the possibility that the sliding support 12 retracts in a third direction C opposite to the first direction A when the flexible screen 14 is forcedly pressed by an external force. Thus, the abutting edge 121 of the sliding support 12 can support the flexible screen 14 more stably to prevent the flexible screen 14 from being damaged due to wrinkles, and improve the working stability of the flexible screen telescopic structure 10.

It should be noted that in this embodiment, the abutting edge 121 is further provided with a rotatable abutting roller 122, and a supporting track 141 is further provided on the back side of the flexible screen 14 to abut against the supporting track 141 by means of the abutting roller 122, thereby reducing the degree of stress on the flexible screen 14 during stretch or retraction.

Further, the flexible screen 14 is wound via the abutting edge 121 to the second side surface 112 of the middle frame support 11 opposite to the first side surface. In addition, the driving mechanism 13 may further include a reset elastic member (not shown), one end of which is connected to a portion of the flexible screen 14 located at the second side surface face 112, and the other end of which is connected to the middle frame support 11, such that when the driving member 131 drives the transmission rope 134, the connecting portion 1341 drives the sliding support 12 to move in the third direction C. At this time, the reset elastic member can also drive the flexible screen 14 to move in the third direction C so as to retract the flexible screen 14 to the second side surface face 112. In other words, when a telescoping mechanism of the flexible screen 14 is stretched, the driving member 131 drives the transmission rope 134, so that the connecting portion 1341 drives the sliding support 12 to move in the first direction A. The reset elastic member is stretched, so that a part of the flexible screen 14 is gradually stretched on the first side surface. When the telescoping mechanism of the flexible screen 14 retracts, the driving member 131 drives the transmission rope 134, so that the connecting portion 1341 drives the sliding support 12 to move in the third direction C. At this time, the reset elastic member drives a part of the flexible screen 14 to gradually retract at the second side surface 112 under the action of its own elastic force. Its structure is relatively simple.

It should be noted that the reset elastic member may also be connected to the sliding support 12. Since the sliding support 12 also moves in the first direction A or the third direction C as the part of the flexible screen 14 located on the second side surface 112, the reset elastic member deforms to a lesser extent and occupies less space, further reducing the volume of the flexible screen telescopic structure 10.

Further, the flexible screen telescopic structure 10 may further include a sliding connecting block 15, and a first sliding rail 1121 may be provided on the middle frame support 11. The first sliding rail 1121 extends in the first direction A. The sliding connecting block 15 is slidably connected to the first sliding rail 1121, and is connected to the sliding support 12 and the connecting portion 1341, so that the sliding support 12 and the connecting portion 1341 are slidably connected by the sliding connecting block 15. This improves the stability of the connecting portion 1341 for driving the sliding support 12.

In addition, a plurality of sliding connecting strips 113 may be provided on the middle frame support 11. A plurality of sliding connecting grooves (not shown) may be provided on the sliding support 12. The plurality of sliding connecting grooves are arranged at intervals, and the plurality of sliding connecting grooves cooperate with the plurality of sliding connecting strips 113, or the plurality of sliding connecting strips 113 are slidably connected to the plurality of sliding connecting grooves one by one so as to slidably connect the sliding support 12 and the middle frame support 11, which improves the stability of the sliding connection between the sliding support 12 and the middle frame support 11 by a plurality of sliding connection positions. In addition, a first side surface is formed by the side surfaces of the plurality of sliding connecting strips 113 together to still provide better support for the flexible screen 14 during movement of the sliding support 12 relative to the middle frame support 11.

Further, the flexible screen telescopic structure 10 may further include a housing 16 which is covered on the second side surface 112. A part of the flexible screen 14 located at the second side surface 112 is located between the middle frame support 11 and the housing 16. The housing 16 is slidably connected to the middle frame support 11 and is also connected to the sliding support 12 so as to slide along the first direction A with the sliding support 12, thereby protecting the flexible screen 14 located at the second side surface 112 via the housing 16.

In addition, the flexible screen telescopic structure 10 may further include a back shell 17 which is connected to the middle frame support 11 and covered on the second side surface 112. The housing 16 is movably sleeved outside the back shell 17, and a part of the flexible screen 14 located at the second side surface 112 is located between the back shell 17 and the second side surface 112, so as to protect the flexible screen 14 located at the second side surface 112 when the housing 16 moves along the first direction A with the sliding support 12.

It should be noted that the back shell 17 may also be a display screen. Also, components such as a battery 20 of the electronic device 100 may be provided between the back shell 17 and the second side surface 112.

The working principle of the flexible screen telescopic structure 10 provided by the embodiments of the present disclosure is as follows.

The flexible screen telescopic structure 10 includes a middle frame support 11, a sliding support 12, a driving mechanism 13 and a flexible screen 14. Herein, the sliding support 12 is slidably connected to the middle frame support 11, and the flexible screen 14 is connected to a first side surface of the middle frame support 11 and bypasses an abutting edge 121 of the sliding support 12. The driving mechanism 13 includes a driving member 131, a guide wheel 133 and a transmission rope 134. The guide wheel 133 is rotatably connected to the middle frame support 11. The transmission rope 134 is wound around the guide wheel 133 and is connected to the driving member 131. The transmission rope 134 is further provided with a connecting portion 1341 which is connected to the sliding support 12. The driving member 131 can drive the transmission rope 134 to move around the guide member 132, and also enables the connecting portion 1341 to drive the sliding support 12 to move in the first direction A parallel to the first side surface, so that the abutting edge 121 moving in the first direction A abuts against the flexible screen 14, and a part of the flexible screen 14 which bypasses the abutting edge 121 is gradually stretched on the first side surface. In other words, as the driving member 131 moves the transmission rope 134, the connecting portion 1341 moves the sliding support 12 relative to the middle frame support 11 in the first direction A, and the abutting edge 121 moving in the first direction A drives the flexible screen 14 which is wound on the abutting edge 121, so that the above-mentioned part of the flexible screen 14 is gradually stretched on the first side surface along the abutting edge 121. The object of stretching the flexible screen 14 is thus achieved by using the sliding support 12 slidably connected to the middle frame support 11. It is simple and compact in structure and makes the overall volume small.

### Conclusions

Embodiments of the present disclosure provide a flexible screen telescopic structure 10 that is compact and small in volume.

## Claims

1. A flexible screen telescopic structure, comprising a middle frame support (11), a sliding support (12), a driving mechanism (13) and a flexible screen (14);
wherein the sliding support (12) is slidably connected to the middle frame support (11), and the flexible screen (14) is connected to a first side surface of the middle frame support (11) and bypasses an abutting edge (121) of the sliding support (12);
the driving mechanism (13) comprises a driving member (131), a guide member (132) and a transmission rope (134), wherein the guide member (132) is rotatably connected to the middle frame support (11); the transmission rope (134) is wound around the guide member (132) and connected to the driving member (131), and the transmission rope (134) is connected to the sliding support (12), with the connected part being a connecting portion (1341); the driving member (131) is used for driving the transmission rope (134) to move around the guide member (132), and enables the connecting portion (1341) to drive the sliding support (12) to move in a first direction (A), thereby pushing the flexible screen (14) through the abutting edge (121), so that the flexible screen (14) moves around the abutting edge (121) and is gradually stretched on the first side surface face, the first direction (A) being parallel to the first side surface face,
wherein the driving mechanism (13) comprises two groups of the guide members (132), each group of the guide members (132) comprising at least one guide wheel (133), the two groups of the guide members (132) being respectively arranged close to both ends of the middle frame support (11) in a second direction (B); the second direction (B) is perpendicular to the first direction (A) and parallel to the first side surface;
the transmission rope (134) is wound around the guide wheels (133) of the two groups of the guide members (132); the transmission rope (134) has two connecting portions (1341) which are respectively arranged close to the both ends of the middle frame support (11) in the second direction (B) for jointly driving the sliding support (12) to slide relative to the middle frame support (11);
**characterized in that**
each group of the guide members (132) comprises two of the guide wheels (133); the transmission rope (134) is wound around four of the guide wheels (133) in an 8-shaped manner in sequence; and two of the connecting portions (1341) are respectively located between two of the guide wheels (133) of each of the two groups of the guide members (132).

2. The flexible screen telescopic structure according to claim 1, **characterized in that** the driving member (131) comprises a driving portion (1311) and a driving wheel (1314) connected to each other; the transmission rope (134) is arranged at least one turn around the driving wheel (1314); and the driving portion (1311) is capable of rotating the driving wheel (1314) so as to move the transmission rope (134) via the driving wheel (1314).

3. The flexible screen telescopic structure according to claim 2, **characterized in that** the transmission rope (134) is endless and wound around the driving wheel (1314) and the guide wheel (133) successively.

4. The flexible screen telescopic structure according to claim 2, **characterized in that** the driving member (131) further comprises a worm wheel (1313) and a worm (1312) cooperating with each other; the worm wheel (1313) is connected to the driving wheel (1314); and the driving portion (1311) is connected to the worm (1312) and can rotate the worm wheel (1313) via the worm (1312), thereby rotating the driving wheel (1314) via the worm wheel (1313).

5. The flexible screen telescopic structure according to any of claims 1-4, **characterized in that** the flexible screen (14) is wound via the abutting edge (121) to a second side surface (112) of the middle frame support (11) opposite to the first side surface;
the driving mechanism (13) further comprises a reset elastic member, one end of the reset elastic member is connected to a portion of the flexible screen (14) located on the second side surface (112), and the other end is connected to the middle frame support (11) or the sliding support (12); the driving member (131) can also move the transmission rope (134) so that the connecting portion (1341) moves the sliding support (12) in a third direction (C) opposite to the first direction (A); and meanwhile, the reset elastic member can move the flexible screen (14) in the third direction (C) so as to retract the flexible screen (14) to the second side surface (112).

6. The flexible screen telescopic structure according to any one of claims 1-4, **characterized in that** the flexible screen telescopic structure further comprises a sliding connecting block (15), and a first sliding rail (1121) is provided on the middle frame support (11);
the first sliding rail (1121) extends in the first direction (A), and the sliding connecting block (15) is slidably connected to the first sliding rail (1121) and is connected to the sliding support (12) and the connecting portion (1341) so as to connect the sliding support (12) and the connecting portion (1341).

7. The flexible screen telescopic structure according to any one of claims 1-4, **characterized in that** a plurality of sliding connecting strips (113) are provided on the middle frame support (11); and a plurality of sliding connecting grooves are provided on the sliding support (12), and the plurality of sliding connecting grooves are arranged at intervals and cooperate with the plurality of sliding connecting strips (113) to slidably connect the sliding support (12) and the middle frame support (11).

8. The flexible screen telescopic structure according to claim 1, **characterized in that** the flexible screen (14) bypasses and moves around the abutting edge (121) and is rolled up at the abutting edge (121).

9. The flexible screen telescopic structure according to claim 1, **characterized in that** the abutting edge (121) is provided with a rotatable abutting roller (122); the back of the flexible screen (14) is provided with a supporting track (141); and the abutting edge (121) abuts against the supporting track (141) via the abutting roller (122).

10. The flexible screen telescopic structure according to claim 1, **characterized in that** the flexible screen telescopic structure further comprises a housing (16);
the housing (16) is covered on the second side surface (112), slidably connected to the middle frame support (11), and connected to the sliding support (12), so that the housing (16) slides along the first direction (A) with the sliding support (12).

11. The flexible screen telescopic structure according to claim 10, **characterized in that** the flexible screen telescopic structure further comprises a back shell (17);
the back shell (17) is covered on the second side surface (112) and connected to the middle frame support (11), and the housing (16) is sleeved outside the back shell (17).

12. An electronic device, **characterized by** comprising a flexible screen telescopic structure according to any of the claims 1-11.

## Patentansprüche

1. Teleskopstruktur für einen flexiblen Bildschirm, mit einer Mittelrahmenhalterung (11), einer verschiebbaren Halterung (12), einem Antriebsmechanismus (13) und einem flexiblen Bildschirm (14);
wobei die verschiebbare Halterung (12) verschiebbar mit der Mittelrahmenhalterung (11) verbunden ist und der flexible Bildschirm (14) mit einer ersten Seitenfläche der Mittelrahmenhalterung (11) verbunden ist und an einer Anschlagkante (121) der verschiebbaren Halterung (12) vorbei geführt ist;
wobei der Antriebsmechanismus (13) ein Antriebselement (131), ein Führungselement (132) und ein Übertragungsseil (134) aufweist, wobei das Führungselement (132) drehbar mit der Mittelrahmenhalterung (11) verbunden ist; das Übertragungsseil (134) um das Führungselement (132) gewickelt und mit dem Antriebselement (131) verbunden ist, und das Übertragungsseil (134) mit der verschiebbaren Halterung (12) verbunden ist, wobei der verbundene Teil ein Verbindungsabschnitt (1341) ist; wobei das Antriebselement (131) ausgebildet ist, das Übertragungsseil (134) anzutreiben, um es um das Führungselement (132) zu bewegen, und es dem Verbindungsabschnitt (1341) zu ermöglichen, die verschiebbare Halterung (12) anzutreiben, um sie in einer ersten Richtung (A) zu bewegen, wodurch der flexible Bildschirm (14) durch die Anschlagkante (121) gedrückt wird, so dass sich der flexible Bildschirm (14) um die Anschlagkante (121) herum bewegt und nach and nach auf der ersten Seitenfläche gestreckt wird, wobei die erste Richtung (A) parallel zu der ersten Seitenfläche verläuft,
wobei der Antriebsmechanismus (13) zwei Gruppen von Führungselementen (132) aufweist, wobei jede Gruppe der Führungselemente (132) mindestens ein Führungsrad (133) aufeist, wobei die beiden Gruppen der Führungselemente (132) entsprechend im Bereich der beiden Enden der Mittelrahmenhalterung (11) in einer zweiten Richtung (B) angeordnet sind; wobei die zweite Richtung (B) senkrecht zu der ersten Richtung (A) und parallel zu der ersten Seitenfläche verläuft;
wobei das Übertragungsseil (134) um die Führungsräder (133) der beiden Gruppen der Führungselemente (132) gewickelt ist; wobei das Übertragungsseil (134) zwei Verbindungsabschnitte (1341) aufweist, die entsprechend im Bereich der beiden Enden der Mittelrahmenhalterung (11) in der zweiten Richtung (B) angeordnet sind, um gemeinsam die verschiebbare Halterung (12) anzutreiben, damit diese sich relativ zu der Mittelrahmenhalterung (11) verschiebt;
**dadurch gekennzeichnet, dass**
jede Gruppe der Führungselemente (132) zwei der Führungsräder (133) aufweist; das Übertragungsseil (134) nacheinander in einer 8-förmigen Weise um vier der Führungsräder (133) gewickelt ist; und zwei der Verbindungsabschnitte (1341) entsprechend zwischen zwei der Führungsräder (133) jeder der beiden Gruppen der Führungselemente (132) angeordnet sind.

2. Teleskopstruktur für einen flexiblen Bildschirm gemäß Anspruch 1, **dadurch gekennzeichnet, dass** das Antriebselement (131) einen Antriebsabschnitt (1311) und ein Antriebsrad (1314) aufweist, die miteinander verbunden sind; das Übertragungsseil (134) mindestens eine Umdrehung um das Antriebsrad (1314) herum angeordnet ist; und der Antriebsabschnitt (1311) ausgebildet ist, das Antriebsrad (1314) so zu drehen, dass das Übertragungsseil (134) mittels des Antriebsrads (1314) in Bewegung versetzt wird.

3. Teleskopstruktur für einen flexiblen Bildschirm gemäß Anspruch 2, **dadurch gekennzeichnet, dass** das Übertragungsseil (134) endlos ist und nacheinander um das Antriebsrad (1314) und das Führungsrad (133) gewickelt ist.

4. Teleskopstruktur für einen flexiblen Bildschirm gemäß Anspruch 2, **dadurch gekennzeichnet, dass** das Antriebselement (131) ferner ein Schneckenrad (1313) und eine Schnecke (1312) aufweist, die miteinander zusammenwirken; das Schneckenrad (1313) mit dem Antriebsrad (1314) verbunden ist; und der Antriebsabschnitt (1311) mit der Schnecke (1312) verbunden ist und das Schneckenrad (1313) über die Schnecke (1312) drehen kann, wodurch das Antriebsrad (1314) über das Schneckenrad (1313) gedreht wird.

5. Teleskopstruktur für einen flexiblen Bildschirm gemäß einem der Ansprüche 1 bis 4, **dadurch gekennzeichnet, dass** der flexible Bildschirm (14) über die Anschlagkante (121) auf eine zweite Seitenfläche (112) der Mittelrahmenhalterung (11), die der ersten Seitenfläche gegenüberliegt, gewickelt ist;
der Antriebsmechanismus (13) ferner ein elastisches Rückstellelement aufweist, wobei ein Ende des elastischen Rückstellelements mit einem Abschnitt des flexiblen Bildschirms (14) verbunden ist, der sich auf der zweiten Seitenfläche (112) befindet, und das andere Ende mit der Mittelrahmenhalterung (11) oder der verschiebbaren Halterung (12) verbunden ist; das Antriebselement (131) ferner das Übertragungsseil (134) bewegen kann, so dass der Verbindungsabschnitt (1341) die verschiebbare Halterung (12) in einer dritten Richtung (C) entgegengesetzt zu der ersten Richtung (A) bewegt; und währenddessen das elastische Rückstellelement den flexiblen Bildschirm (14) in die dritte Richtung (C) bewegen kann, um den flexiblen Bildschirm (14) zu der zweiten Seitenfläche (112) zurückzuziehen.

6. Teleskopstruktur für einen flexiblen Bildschirm gemäß einem der Ansprüche 1 bis 4, **dadurch gekennzeichnet, dass** die Teleskopstruktur für einen flexiblen Bildschirm ferner einen verschiebbaren Verbindungsblock (15) aufweist und eine erste Gleitschiene (1121) an der Mittelrahmenhalterung (11) vorgesehen ist;
sich die erste Gleitschiene (1121) in der ersten Richtung (A) erstreckt und der verschiebbare Verbindungsblock (15) gleitfähig mit der ersten Gleitschiene (1121) verbunden ist und mit der verschiebbaren Halterung (12) und dem Verbindungsabschnitt (1341) verbunden ist, um die verschiebbare Halterung (12) und den Verbindungsabschnitt (1341) zu verbinden.

7. Teleskopstruktur für einen flexiblen Bildschirm gemäß einem der Ansprüche 1 bis 4, **dadurch gekennzeichnet, dass** mehrere Gleitverbindungsstreifen (113) an der Mittelrahmenhalterung (11) vorgesehen sind; und mehrere Gleitschlitze an der verschiebbaren Halterung (12) vorgesehen sind, wobei die mehreren Gleitschlitze in Abständen angeordnet sind und mit den mehreren Gleitverbindungsstreifen (113) zusammenwirkt, um die verschiebbare Halterung (12) und die Mittelrahmenhalterung (11) verschiebbar zu verbinden.

8. Teleskopstruktur für einen flexiblen Bildschirm gemäß Anspruch 1, **dadurch gekennzeichnet, dass** der flexible Bildschirm (14) die Anschlagkante (121) umgeht und um diese herum bewegt wird und an der Anschlagkante (121) aufgerollt wird.

9. Teleskopstruktur für einen flexiblen Bildschirm gemäß Anspruch 1, **dadurch gekennzeichnet, dass** die Anschlagkante (121) mit einer drehbaren Anschlagrolle (122) versehen ist; die Rückseite des flexiblen Bildschirms (14) mit einer Stützschiene (141) versehen ist; und die Anschlagkante (121) über die Anschlagrolle (122) an der Stützschiene (141) anliegt.

10. Teleskopstruktur für einen flexiblen Bildschirm gemäß Anspruch 1, **dadurch gekennzeichnet, dass** die Teleskopstruktur für einen flexiblen Bildschirm ferner ein Gehäuse (16) aufweist;
das Gehäuse (16) auf der zweiten Seitenfläche (112) abgedeckt ist, verschiebbar mit der Mittelrahmenhalterung (11) verbunden ist und mit der verschiebbaren Halterung (12) verbunden ist, so dass das Gehäuse (16) mit der verschiebbaren Halterung (12) entlang der ersten Richtung (A) verschiebbar ist.

11. Teleskopstruktur für einen flexiblen Bildschirm gemäß Anspruch 10, **dadurch gekennzeichnet, dass** die Teleskopstruktur für einen flexiblen Bildschirm ferner eine Rückenschale (17) aufweist;
die Rückenschale (17) auf der zweiten Seitenfläche (112) abgedeckt und mit der Mittelrahmenhalterung (11) verbunden ist und das Gehäuse (16) außerhalb der Rückenschale (17) ummantelt ist.

12. Elektronisches Vorrichtung, **gekennzeichnet durch** eine Teleskopstruktur für einen flexiblen Bildschirm gemäß einem der Ansprüche 1 bis 11.

## Revendications

1. Structure télescopique d'écran souple, comprenant un support de cadre central (11), un support coulissant (12), un mécanisme d'entraînement (13) et un écran souple (14) ;
dans laquelle le support coulissant (12) est relié en coulissement au support de cadre central (11), et l'écran souple (14) est relié à une première surface latérale du support de cadre central (11) et contourne un bord d'aboutement (121) du support coulissant (12) ;
le mécanisme d'entraînement (13) comprend un élément d'entraînement (131), un élément de guidage (132) et un câble de transmission (134), dans lequel l'élément de guidage (132) est relié en rotation au support de cadre central (11) ; le câble de transmission (134) est enroulé autour de l'élément de guidage (132) et relié à l'élément d'entraînement (131), et le câble de transmission (134) est relié au support coulissant (12), la partie reliée étant une partie de liaison (1341) ; l'élément d'entraînement (131) est utilisé pour entraîner la corde de transmission (134) afin qu'elle se déplace autour de l'élément de guidage (132), et permet à la partie de liaison (1341) d'entraîner le support coulissant (12) pour qu'il se déplace dans une première direction (A), poussant ainsi l'écran souple (14) à travers le bord d'aboutement (121), de sorte que l'écran souple (14) se déplace autour du bord d'aboutement (121) et soit progressivement tendu sur la première face de surface latérale, la première direction (A) étant parallèle à la première face de surface latérale,
dans laquelle le mécanisme d'entraînement (13) comprend deux groupes d'éléments de guidage (132), chaque groupe d'éléments de guidage (132) comprenant au moins une roue de guidage (133), les deux groupes d'éléments de guidage (132) étant respectivement agencés à proximité des deux extrémités du support de cadre central (11) dans une deuxième direction (B) ; la deuxième direction (B) est perpendiculaire à la première direction (A) et parallèle à la première surface latérale ;
le câble de transmission (134) est enroulé autour des roues de guidage (133) des deux groupes d'éléments de guidage (132) ; le câble de transmission (134) a deux parties de liaison (1341) qui sont respectivement agencées à proximité des deux extrémités du support de cadre central (11) dans la deuxième direction (B) pour entraîner conjointement le support coulissant (12) à coulisser par rapport au support de cadre central (11) ;
**caractérisée en ce que**
chaque groupe d'éléments de guidage (132) comprend deux roues des roues de guidage (133) ; le câble de transmission (134) est enroulé de manière séquentielle autour de quatre roues des roues de guidage (133) selon une configuration en forme de 8 ; et deux parties des parties de liaison (1341) sont respectivement situées entre deux roues des roues de guidage (133) de chacun des deux groupes d'éléments de guidage (132).

2. Structure télescopique d'écran souple selon la revendication 1, **caractérisée en ce que** l'élément d'entraînement (131) comprend une partie d'entraînement (1311) et une roue d'entraînement (1314) reliées l'une à l'autre ; le câble de transmission (134) est agencé en au moins un tour autour de la roue d'entraînement (1314) ; et la partie d'entraînement (1311) est capable de faire tourner la roue d'entraînement (1314) de manière à déplacer le câble de transmission (134) par l'intermédiaire de la roue d'entraînement (1314).

3. Structure télescopique d'écran souple selon la revendication 2, **caractérisée en ce que** le câble de transmission (134) est sans fin et enroulé successivement autour de la roue d'entraînement (1314) et de la roue de guidage (133).

4. Structure télescopique d'écran souple selon la revendication 2, **caractérisée en ce que** l'élément d'entraînement (131) comprend en outre une roue à vis sans fin (1313) et une vis sans fin (1312) coopérant l'une avec l'autre ; la roue à vis sans fin (1313) est reliée à la roue d'entraînement (1314) ; et la partie d'entraînement (1311) est reliée à la vis sans fin (1312) et peut faire tourner la roue à vis sans fin (1313) par l'intermédiaire de la vis sans fin (1312), faisant ainsi tourner la roue d'entraînement (1314) par l'intermédiaire de la roue à vis sans fin (1313).

5. Structure télescopique d'écran souple selon l'une des revendications 1 à 4, **caractérisée en ce que** l'écran souple (14) est enroulé par l'intermédiaire du bord d'aboutement (121) sur une deuxième surface latérale (112) du support de cadre central (11) opposée à la première surface latérale ;
le mécanisme d'entraînement (13) comprend en outre un élément élastique de réinitialisation, une extrémité de l'élément élastique de réinitialisation est reliée à une partie de l'écran souple (14) située sur la deuxième surface latérale (112), et l'autre extrémité est reliée au support de cadre central (11) ou au support coulissant (12) ; l'élément d'entraînement (131) peut également déplacer le câble de transmission (134) de sorte que la partie de liaison (1341) déplace le support coulissant (12) dans une troisième direction (C) opposée à la première direction (A) ; et pendant ce temps, l'élément élastique de réinitialisation peut déplacer l'écran souple (14) dans la troisième direction (C) de manière à rétracter l'écran souple (14) vers la deuxième surface latérale (112).

6. Structure télescopique d'écran souple selon l'une quelconque des revendications 1 à 4, **caractérisée en ce que** la structure télescopique d'écran souple comprend en outre un bloc de liaison coulissant (15), et un premier rail coulissant (1121 ) est prévu sur le support de cadre central (11) ;
le premier rail coulissant (1121) s'étend dans la première direction (A), et le bloc de liaison coulissant (15) est relié en coulissement au premier rail coulissant (1121) et est relié au support coulissant (12) et à la partie de liaison (1341) de manière à relier le support coulissant (12) et la partie de liaison (1341).

7. Structure télescopique d'écran souple selon l'une quelconque des revendications 1 à 4, **caractérisée en ce qu'**une pluralité de bandes de liaison coulissantes (113) sont prévues sur le support de cadre central (11) ; et une pluralité de rainures de liaison coulissantes sont prévues sur le support coulissant (12), et la pluralité de rainures de liaison coulissantes sont agencées à des intervalles et coopèrent avec la pluralité de bandes de liaison coulissantes (113) pour relier en coulissement le support coulissant (12) et le support de cadre central (11).

8. Structure télescopique d'écran souple selon la revendication 1, **caractérisée en ce que** l'écran souple (14) contourne et se déplace autour du bord d'aboutement (121) et est replié au niveau du bord d'aboutement (121).

9. Structure télescopique d'écran souple selon la revendication 1, **caractérisée en ce que** le bord d'aboutement (121) est pourvu d'un rouleau d'aboutement rotatif (122) ; l'arrière de l'écran souple (14) est pourvu d'une glissière de support (141) ; et le bord d'aboutement (121) vient en butée contre la glissière de support (141) par l'intermédiaire du rouleau d'aboutement (122).

10. Structure télescopique d'écran souple selon la revendication 1, **caractérisée en ce que** la structure télescopique d'écran souple comprend en outre un boîtier (16) ;
le boîtier (16) est recouvert sur la deuxième surface latérale (112), relié en coulissement au support de cadre central (11) et relié au support coulissant (12), de sorte que le boîtier (16) coulisse le long de la première direction (A) avec le support coulissant (12).

11. Structure télescopique d'écran souple selon la revendication 10, **caractérisée en ce que** la structure télescopique d'écran souple comprend en outre une coque arrière (17) ;
la coque arrière (17) est recouverte sur la deuxième surface latérale (112) et reliée au support de cadre central (11), et le boîtier (16) est emboîté à l'extérieur de la coque arrière (17).

12. Dispositif électronique, **caractérisé en ce qu'**il comprend une structure télescopique d'écran souple selon l'une des revendications 1 à 11.
